# EUROPÄISCHE PATENTSCHRIFT

(11) **EP 0 524 377 B1**
(45) Veröffentlichungstag und Bekanntmachung des Hinweises auf die Patenterteilung: **13.12.1995**
(21) Anmeldenummer: 92106566.0
(22) Anmeldetag: 16.04.1992
(51) Int. Cl.: H01M 10/48, H01M 2/20

(54) **Akkumulatorenbatterie mit Kontrollvorrichtung am Zellenverbinder**
Accumulator battery with control device in an intercell connector
Batterie d'accumulateurs à organe de contrôle fixé au connecteur intercellulaire

(30) Priorität: 15.07.1991 DE 4123361
(43) Veröffentlichungstag der Anmeldung: 27.01.1993
(73) Patentinhaber: VARTA Batterie Aktiengesellschaft, D-30405 Hannover (DE)
(72) Erfinder: Falk, Klaus-Martin, W-5800 Hagen (DE); Rusch, Wieland, Dr., W-4770 Soest (DE); Schmidt, Hartmut, Dipl.-Ing., W-5820 Gevelsberg (DE); Thomas, Joachim, Dipl.-Ing., W-5800 Hagen (DE)
(74) Vertreter: Kaiser, Dieter Ralf, Dipl.-Ing.

(56) Entgegenhaltungen:
- WO-A-90/01221
- DE-A- 3 628 600
- DE-A- 3 907 697
- FR-A- 2 525 397
- US-A- 4 237 198
- US-A- 4 680 527

## Beschreibung

Die Erfindung betrifft eine Akkumulatorenbatterie, deren Zellen auf der Oberseite des Gehäuses durch an den Zellenpolen angebrachte Zellenverbinder elektrisch verbunden sind, wobei die Zellenverbinder zur Überwachung des Betriebszustandes der Batterie mit einem Meßwiderstand und Anschlüssen für Meßeinrichtungen versehen sind. Vorzugsweises Anwendungsgebiet der Erfindung sind Bleiakkumulatoren, die ununterbrochenen starken Zyklenbelastungen unterliegen wie etwa in der Elektrotraktion.

Unter schonenden Bedingungen zeigen Akkumulatoren einen charakteristischen zeitlichen Verlauf des Ladestromes und des Entladestromes, mit denen zu jedem Zeitpunkt bestimmte Werte der Spannung, der Temperatur und gegebenenfalls des Drucks korrespondieren. Aus den genannten Betriebsparametern ergibt sich ein "Benutzungsprofil" über der Zeit, welches typenspezifisch ist. Akkumulatorenzellen und -batterien verfügen auf diese Weise über eine Kennung, die eine Typenidentifizierung ermöglicht und es vor allem gestattet, das Ladeverfahen dem jeweiligen Batterietyp individuell anzupassen.

Bei starker Beanspruchung der Batterie durch einen Verbraucher ist das Benutzungsprofil ihrer Betriebsparameter erheblich verzerrt, so daß deren ständige Kontrolle besonders wichtig wird, um das Ladegerät entsprechend dem aktuellen Betriebszustand zu steuern. Dies geschieht beispielsweise während des Einsatzes von Bleibatterien als Energiespeicher in Flurförderzeugen (Gabelstapler etc.). Dabei spielen allein vor dem Hintergrund der Fuhrparkorganisation Fragen nach der Auslastung der Batterien, ihrer momentanen Leistungsfähigkeit, dem Stand der Istkapazität oder nach den Einsatzbedingungen (Tiefentladung, hohe Temperaturen) eine entscheidende Rolle.

Für einen optimalen Betrieb des Akkumulators ist daher vor allem die Überwachung des Ladezustandes notwendig. Man kann diesen bewerten, indem man den Ladestrom und den Entladestrom mit einem Meßwiderstand mißt. Der Meßwiderstand kann sich z. B. im Ladegerät oder in der Minusleitung des Anschlußkabels befinden. Da er Meßleitungen zur Batterie und zu einer Auswertungseinrichtung benötigt, die sich gegebenenfalls um weitere Meßleitungen zu einem Temperaturfühler vermehren, ergibt sich eine Meßeinrichtung, die unhandlich und bei Wartungs- oder Reinigungsarbeiten zudem störend ist.

Bei einem bekannten mehrzelligen Akkumulator gemäß DE-OS 36 28 600 bildet der Meßwiderstand ein mittleres Teilstück eines Zellenverbinders mit elastisch verformbaren Enden, wobei Meßleitungen aus dem kunststoffummantelten Meßwiderstand herausführen und ihn mit der Auswertungseinrichtung verbinden.

Der Erfindung liegt die Aufgabe zugrunde, von der Möglichkeit einer unmittelbaren Anordnung des Meßwiderstandes am Akkumulator ausgehend eine in diesem Sinne verbesserte Batteriekonstruktion anzugeben und mit der Meßeinrichtung zugleich mehr Informationen verfügbar zu machen.

Die Aufgabe wird durch eine Akkumulatorenbatterie gelöst, wie sie im Patentanspruch 1 definiert ist.

Kern der Erfindung ist danach ein Meßwiderstand zum Erfassen der eingangs erwähnten Betriebsparameter in Gestalt eines Zellenverbinders, zumindest eines integralen Teilabschnitts dieses Zellenverbinders, welcher wie gewöhnliche Ausführungsformen von Verbindern ein über seine volle Länge starres Metallstück ist. Es wird wie jene mit den Enden auf die entgegengesetzten Pole zweier benachbarter Zellen aufgeschraubt.

Das vorzugsweise Material des Verbinders gemäß der Erfindung ist Kupfer. Vorzugsweise kann Konstantan, eine Legierung aus 40 % Ni und 60 % Cu verwendet werden, weil deren Leitvermögen einen sehr geringen Temperaturkoeffizienten aufweist. Diesem meßtechnischen Vorteil steht allerdings der Nachteil eines vergrößerten Leitungswiderstandes gegenüber. Unabhängig von der Wahl des Verbindermaterials kann der Meßwiderstand über den Querschnitt des Verbinders den Erfordernissen angepaßt werden.

Anhand zweier Figuren wird der Gegenstand der Erfindung näher erläutert.

Figur 1 zeigt die Konstruktion des Zellenverbinders in einem Aufriß.

Figur 2 zeigt die Verschaltung des Verbinders auf einer Batterie.

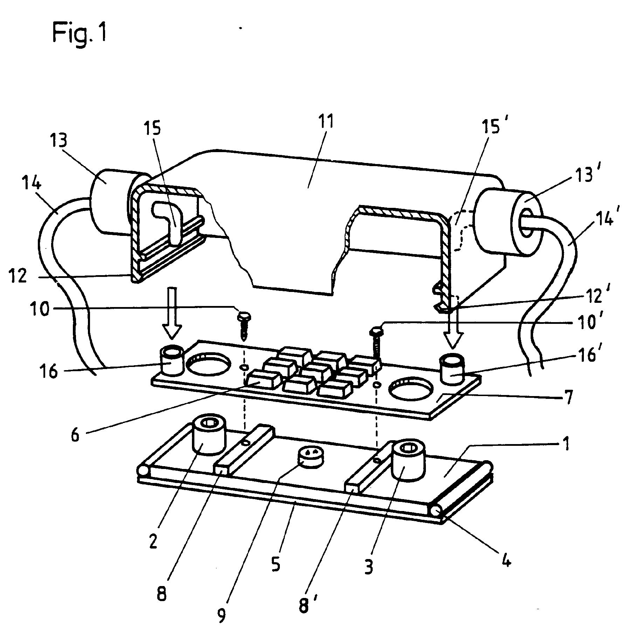

Nach Figur 1 ist der Verbinder 1 aus Kupfer und mit definiertem Querschnitt über der Oberfläche eines Batteriegehäuses mittels platzsparender Imbusschrauben 2,3 auf die - nicht sichtbaren - Gegenpole zweier benachbarter Zellen aufgeschraubt. Die Pole stehen in einem Normalabstand auseinander. Um dennoch Einbautoleranzen auszugleichen, sitzen die Imbusschrauben vorzugsweise in Langlöchern (nicht sichtbar) des Verbinders.

Mit 4 sind Dichtelemente und mit 5 Kunststoffumspritzungen angedeutet, welche den Verbinder gegebenenfalls vollständig umhüllen und ihn säuredicht verkapseln.

In geringem Abstand oberhalb des Verbinders und parallel zu diesem ist eine mit elektronischen Bausteinen 6 besetzte Platine 7 angeordnet und auf Isolierstützen 8, 8′ sowie auf einem Fühler 9 zur Messung der Temperatur des Verbinders gelagert. Zwei Schrauben 10, 10′ dienen zur Befestigung der Platine am Verbinder und zum Abgriff der Meßspannung.

Nach der Montage der Platine wird der Verbinder gemäß Erfindung durch einen schützenden Deckel 11 komplettiert. Zu seiner Befestigung sind Rastverbindungen über Schnappkanten 12, 12′ oder dergl. vorgesehen. Aus dem Deckel sind über Schraubbuchsen 13, 13′ lösbar befestigte, bewegliche Kabel bzw. Datenübertragungsleitungen 14, 14′ herausgeführt, die mit den Endpolen der Batterie (nicht dargestellt) verbunden werden. Der Anschluß der Kabel an die Platine erfolgt mittels Kontakten 15, 15′, die kraftschlüssig mit dem Deckel verbunden sind. Beim Einrasten des Deckels werden die Kontakte (siehe Pfeile) in die Steckerbuchsen 16, 16′ auf der Platine eingeschoben.

Die elektronischen Bausteine auf der Platine beinhalten Halbleiterchips mit elektronischen Schaltkreisen, Widerstände, Dioden und dergleichen. Der Verbinder gemäß Erfindung verfügt damit über eine elektronische Auswertungsschaltung, die es gestattet, die zeitlichen Verläufe von Lade- und Entladeströmen, der Spannung und der Temperatur nach Maßgabe der Meßspannung über dem Spannungsabgriff am Verbinder zu erfassen und auch zu speichern; der erfindungsgemäße Verbinder kann daher als "intelligenter Verbinder" bezeichnet werden.

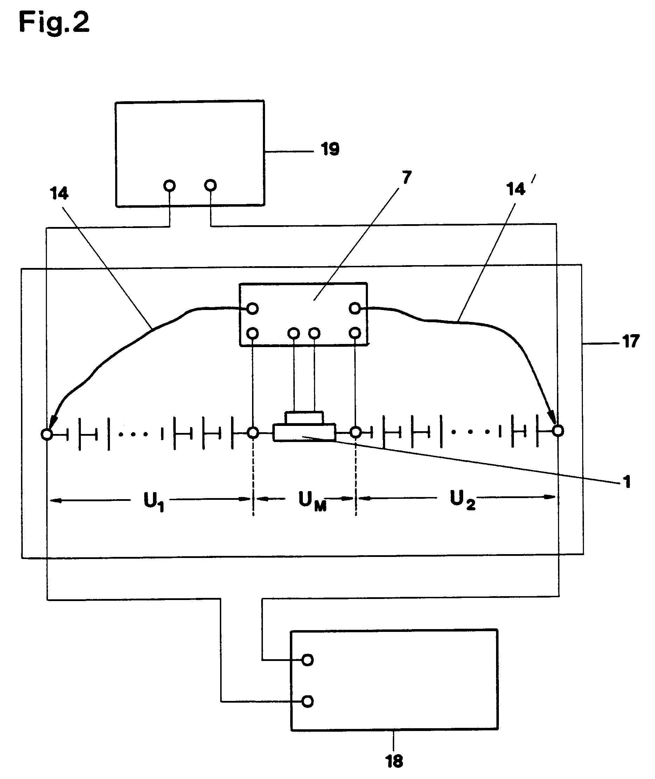

Gemäß dem Schaltungsschema in Figur 2 ist der Verbinder 1 auf der Akkumulatorenbatterie 17 vorzugsweise so positioniert, daß sich links und rechts von ihm gleichviele Zellen befinden, die Schaltung quasi eine "Batteriewaage" bildet. Vorausgesetzt, daß keine der Zellen fehlerhaft ist, registriert die Elektronik auf der Platine 7 in diesem Fall außer der Meßspannung U_{M} am Verbinder und der Thermospannung des Temperaturmeßfühlers 9 zwei Batterie-Teilspannungen U₁ und U₂ von gleicher Größe. Ungleichheit dieser Spannungen deutet auf eine defekte Zelle hin.

Über die äußeren Leitungen 14, 14′ der Platine gelangen die erfaßten Daten frequenzmoduliert zu den Batterieendpolen und von dort weiter über das Energiekabel zur Auswertungseinrichtung im Ladegerät 18. Über die Leitungen 14, 14′ wird die Schaltelektronik auf der Platine zugleich mit der notwendigen Energie versorgt. Mit 19 ist ein Verbraucher bezeichnet.

Mit dem intelligenten Verbinder können insbesonders gemessen werden die Strommenge über den Meßwiderstand; die Verbindertemperatur über den Temperaturmeßfühler; die Potentiallage der Batteriemitte relativ zu den Potentialen der Endpole bei Belastung der Batterie; die Batteriespannung; die Entlade- oder Ladezeit. Zugleich gibt die Elektronik des Verbinders Steuersignale an das Ladegerät ab.

Die Auswertungseinrichtung im Ladegerät übernimmt die Integration der Strommenge über eine Entladung und Ladung, die Bestimmung des Ladefaktors, die Ermittlung der Zyklenzahl und der Höhe des mittleren Entladestromes. Durch Vergleich der entnommenen Strommenge und der Batteriespannung unter Berücksichtigung der Batterietemperatur und des Entladestromes kann die Istkapazität der Batterie ermittelt werden.

Durch Vergleich der Teilspannungen der beiden Batteriehälften während der Entladebelastung werden fehlerhafte Zellen erkannt. Durch die Auswertung der Temperatur, des Ladefaktors, der Tiefentladung, der Ruhespannung und der Istkapazität werden Streßbedingungen der Batterie erkennbar, wie zu hohe Temperaturen, starke Überladung, Tiefentladungen, lange Perioden im entladenen Zustand und Absinken des Säurespiegels.

## Patentansprüche

1. Akkumulatorenbatterie, deren Zellen auf der Oberseite des Gehäuses durch an den Zellenpolen angebrachte Zellenverbinder elektrisch verbunden sind, wobei die Zellenverbinder (1) zur Überwachung des Betriebszustandes der Batterie mit einem Meßwiderstand und Anschlüssen für Meßeinrichtungen versehen sind, dadurch gekennzeichnet, daß der Meßwiderstand ein mittlerer Teilabschnitt eines über seine volle Länge starren Zellenverbinders (1) ist und daß dieser Zellenverbinder eine elektronische Auswertungsschaltung (6) besitzt, die es gestattet, die zeitlichen Verläufe von Lade- und Entladeströmen, der Spannungen und der Temperatur zu erfassen, zu bewerten und zu speichern und die mit zwei beweglichen äußeren Leitungen (14, 14′) an die Endpole der Batterie anschließbar ist.

2. Akkumulatorenbatterie nach Anspruch 1, dadurch gekennzeichnet, daß die elektronische Auswertungsschaltung im Abstand oberhalb des Verbinders auf einer Platine (7) angeordnet ist und daß die Platine am Verbinder mittels Schrauben (10, 10′) befestigt ist, zwischen denen die über dem Meßwiderstand liegende Spannung abgreifbar ist.

3. Akkumulatorenbatterie nach Anspruch 2, dadurch gekennzeichnet, daß an dem den Meßwiderstand bildenden Verbinderabschnitt ein Temperaturfühler (9) vorhanden ist.

4. Akkumulatorenbatterie nach einem der Ansprüche 1 bis 3, dadurch gekennzeichnet, daß die beweglichen äußeren Leitungen mittels Steckverbindungen (15, 16) (15′, 16′) mit der Platine kontaktierbar sind.

5. Akkumulatorenbatterie nach einem der Ansprüche 1 bis 4, dadurch gekennzeichnet, daß der Verbinder mitsamt zugehöriger Elektronik in einen Schutzdeckel 11 gekapselt ist.

## Claims

1. An accumulator battery whereof the cells are electrically connected on the upper side of the housing by cell connectors attached to the cell poles, the cell connectors (1) being provided with a measuring resistor and terminals for measuring devices for the purpose of monitoring the operating state of the battery, characterized in that the measuring resistor is a central portion of a cell connector (1) which is rigid over its entire length, and in that this cell connector has an electronic evaluation circuit (6) which enables the time profiles of charging and discharging currents, the voltages and the temperature to be detected, evaluated and stored and which can be attached to the terminal poles of the battery by means of two movable external lines (14, 14′).

2. An accumulator battery according to Claim 1, characterized in that the electronic evaluation circuit is arranged spaced above the connector on a circuit board (7), and in that the circuit board is secured to the connector by means of screws (10, 10′) between which the voltage applied across the measuring resistor can be picked off.

3. An accumulator battery according to Claim 2, characterized in that a temperature sensor (9) is provided at the connector portion forming the measuring resistor.

4. An accumulator battery according to one of Claims 1 to 3, characterized in that contact between the movable external lines and the circuit board can be made by means of plug-type connections (15, 16) (15′, 16′).

5. An accumulator battery according to one of Claims 1 to 4, characterized in that the connector is encapsulated in a protective cover 11 together with all the associated electronics.

## Revendications

1. Batterie d'accumulateurs dont les éléments sont reliés électriquement sur le côté supérieur du carter par des connecteurs intercellulaires rapportés aux pôles des éléments, les connecteurs intercellulaires (1) étant munis pour la surveillance de l'état de fonctionnement de la batterie d'une résistance de mesure et de raccordements pour des dispositifs de mesure,
batterie d'accumulateur caractérisée en ce que la résistance de mesure est un tronçon partiel média d'un connecteur intercellulaire (1) rigide sur toute sa longueur et en ce que ce connecteur cellulaire comporte un montage électronique d'exploitation (6) qui permet de détecter les évolutions dans le temps des courants de charge et de décharge, des tensions et de la température, de les évaluer et de les mémoriser et qui est susceptible d'être raccordé aux pôles terminaux de la batterie par deux conduites externes mobiles (14, 14′).

2. Batterie d'accumulateurs selon la revendication 1 caractérisée en ce que le montage électronique d'exploitation est disposé à une certaine distance au-dessus du connecteur sur une platine (7) et que cette platine est fixée au connecteur au moyen de vis (10, 10′) entre lesquelles peut être prise la tension se situant sur la résistance de mesure.

3. Batterie d'accumulateurs selon la revendication 2 caractérisée en ce que sur le tronçon du connecteur constituant la résistance de mesure un détecteur de température (9) est prévu.

4. Batterie d'accumulateurs selon l'une des revendications 1 à 3 caractérisée en ce que les conduites externes mobiles son mises en contact avec la platine au moyen de liaisons par enfichage (15, 16) (15′, 16′).

5. Batterie d'accumulateurs selon l'une des revendications 1 à 4 caractérisée en ce que le connecteur est encapsulé dans un couvercle de protection (11) avec toute l'électronique correspondante.
